# EUROPEAN PATENT APPLICATION

(11) **EP 3 790 060 A1**
(43) Date of publication of application: **10.03.2021**
(21) Application number: 19883328.7
(22) Date of filing: 23.08.2019
(51) Int. Cl.: H01L 31/05, H01L 31/0224, H01L 31/042, H01L 31/068

(54) **PHOTOVOLTAIC CELL ARRAY AND PHOTOVOLTAIC ASSEMBLY**

(30) Priority: 28.05.2019 CN 201910454083; 28.05.2019 CN 201920785516 U
(71) Applicant: Zhejiang Jinko Solar Co., Ltd., Haining, Zhejiang 314416 (CN)
(72) Inventor: WANG, Juan, Zhejiang 314416 (CN); GUO, Zhiqiu, Zhejiang 314416 (CN); SUN, Changzhen, Zhejiang 314416 (CN); JIN, Hao, Zhejiang 314416 (CN)
(74) Representative: Detken, Andreas
(86) International application number: PCT/CN2019/102127
(87) International publication number: WO 2020/237854

(57) **Abstract**

A photovoltaic cell array and a photovoltaic module are provided. The photovoltaic cell array includes multiple solar cells and a flexible metal conductive strip. Each of an upper surface and a lower surface of each of the multiple solar cells is arranged with a segment electrode. In adjacent two of the multiple solar cells which are respectively referred to as a first solar cell and a second solar cell, the segment electrode on the lower surface of the first solar cell is connected with the segment electrode on the upper surface of the second solar cell by the flexible metal conductive strip. The photovoltaic cell array has a stack structure in a normal direction of the upper surface of each of the multiple solar cells, and a connection region at which the segment electrode is connected with the flexible metal conductive strip is located outside an overlapped region of the stack structure. Two adjacent solar cells in the photovoltaic cell array are connected with each other by the flexible metal conductive strip, since the flexible metal conductive strip has a small resistance and small power consumption, the output power of the photovoltaic cell array can be improved. In addition, since the photovoltaic cell array has the stack structure, the number of the solar cells can be increased for the photovoltaic cell array with a fixed length, thereby improving the output power of the photovoltaic cell array.

## Description

The present application claims priority to Chinese Patent Application No. 201910454083.4, titled "PHOTOVOLTAIC CELL ARRAY AND PHOTOVOLTAIC MODULE", and filed on May 28, 2019 with the Chinese Patent Office, and Chinese Patent Application No. 201920785516.X, titled "PHOTOVOLTAIC CELL ARRAY AND PHOTOVOLTAIC MODULE", and filed on May 28, 2019 with the Chinese Patent Office, both of which are incorporated herein by reference in their entireties.

### FIELD

The present disclosure relates to the technical field of solar cells, and in particular to a photovoltaic cell array and a photovoltaic module.

### BACKGROUND

With the rapid development of the society, there is an increasing demand for energy. However, there is limited amount of fossil energy, which cannot satisfy the long-period demand of social development. Moreover, consumption of the fossil energy may result in serious environmental pollution. Therefore, in order to promote harmonious development of the society, it is required to develop a new energy to replace the fossil energy. The solar energy, as a renewable energy, has unlimited reserves and is free for use, and no pollutant is caused in the process of using the solar energy. Therefore, photovoltaic industry develops rapidly in recent years.

In order to satisfy the demands for industry development and customers, photovoltaic enterprises have to reduce a power loss inside a photovoltaic module and increase output power of the photovoltaic module. In order to increase the output power of the photovoltaic module, the photovoltaic enterprises introduce multiple photovoltaic module fabricating technologies, such as an imbricate technology. In the imbricate technology, a square (quasi square) solar cell is divided into multiple rectangular (quasi rectangular) sub-solar cells, and a front electrode in one sub-cell and a back electrode in an adjacent sub-solar cell are overlapped with each other via conducting resin to form a series circuit. A current between adjacent sub-solar cells transmits in a direction perpendicular to a surface of the sub-solar cell, such that a current inside the module is small and a light receiving area of the module is large, thereby increasing the power and efficiency of the module.

Compared with a conventional module, although output power of an imbricate photovoltaic module is improved, processes such as applying conducting resin, curing and terminal welding and related devices are additionally required, which results in a complex process and a high production cost. In addition, the conducting resin has a large resistance, resulting in a high loss inside the imbricate photovoltaic module.

### SUMMARY

An object of the present disclosure is to provide a photovoltaic cell array and a photovoltaic module, which have increased output power and reduced production cost.

In order to solve the above technical problem, the photovoltaic cell array according to the present disclosure includes multiple solar cells and a flexible metal conductive strip. Each of an upper surface and a lower surface of each of the multiple solar cells is arranged with a segment electrode. In adjacent two of the multiple solar cells which are respectively referred to as a first solar cell and a second solar cell, the segment electrode on the lower surface of the first solar cell is connected with the segment electrode on the upper surface of the second solar cell by the flexible metal conductive strip. The photovoltaic cell array has a stack structure in a normal direction of the upper surface of each of the multiple solar cells, and a connection region at which the segment electrode is connected with the flexible metal conductive strip is arranged outside an overlapped region of the stack structure.

In an embodiment, in a case that the segment electrode is arranged in a direction perpendicular to a first side of the solar cell, the number of the segment electrode arranged on each of the upper surface and the lower surface of the solar cell ranges from 4 to 9, inclusive. The solar cell is a rectangular plate, and the first side is a long side of the solar cell.

In an embodiment, the segment electrode is arranged uniformly on each of the upper surface and the lower surface of the solar cell.

In an embodiment, a width of the segment electrode ranges from 0.5mm to 5mm, inclusive.

In an embodiment, a length of the segment electrode ranges from 1mm to 15mm, inclusive.

In an embodiment, a thinkness of the flexible metal conductive strip is less than 200µm.

In an embodiment, the adjacent two solar cells are stacked with each other along a first side of each of the two adjacent solar cells to form the stack structure. The solar cell is a rectangular plate, and the first side is a long side of the solar cell.

In an embodiment, an angle between the segment electrode and a first side of the solar cell is an acute angle.

In an embodiment, a width of the overlapped region of the stack structure is less than 2mm.

The photovoltaic module according to the present disclosure includes any one of photovoltaic cell arrays described above.

A photovoltaic cell array and a photovoltaic module are provided. The photovoltaic cell array includes multiple solar cells and a flexible metal conductive strip. Each of an upper surface and a lower surface of each of the multiple solar cells is arranged with a segment electrode. In adjacent two of the multiple solar cells which are respectively referred to as a first solar cell and a second solar cell, the segment electrode on the lower surface of the first solar cell is connected with the segment electrode on the upper surface of the second solar cell with the flexible metal conductive strip. The photovoltaic cell array has a stack structure in a normal direction of the upper surface of each of the multiple solar cells, and a connection region at which the segment electrode is connected with the flexible metal conductive strip is located outside an overlapped region of the stack structure. In the present disclosure, two adjacent solar cells in the photovoltaic cell array are connected with each other by the flexible metal conductive strip, since the flexible metal conductive strip has a low cost, a small resistance, and a small power consumption, the output power of the photovoltaic cell array can be improved and the production cost of the module can be reduced. In addition, since the adjacent two solar cells in the photovoltaic cell array form the stack structure in the normal direction of the upper surface of the solar cell, the number of the solar cells can be increased for the photovoltaic cell array with a fixed length, such that the light receiving area is increased, thereby improving the output power of the photovoltaic cell array.

### BRIEF DESCRIPTION OF THE DRAWINGS

In order to more clearly illustrate technical solutions according to embodiments of the present disclosure, drawings used in the description of the embodiments are briefly described below. It is apparent that the drawings in the following description show merely some embodiments of the present disclosure, and other drawings may be obtained based on these drawings by those skilled in the art without any creative effort.
Figure 1 is a cross-sectional view of adjacent two solar cells in a photovoltaic cell array according to the present disclosure in a direction along a short side of each of the adjacent two solar cells;
Figure 2 to Figure 6 are schematic diagrams each shows a distribution pattern of metal fine grid wires on a surface of a solar cell;
Figure 7 is a schematic diagram shows a distribution pattern of metal fine grid wires on a surface of a solar cell in a case that a segment electrode is arranged in parallel to a long side of the solar cell; and
Figure 8 is a schematic structural diagram of a photovoltaic module according to an embodiment of the present disclosure.

### DETAILED DESCRIPTION OF EMBODIMENTS

In order to help those skilled in the art to understand the solutions of the present disclosure better, the present disclosure is further described in detailed below in conjunction with the drawings. It is apparent that, the described embodiments are only some embodiments, rather than all embodiments of the present disclosure. Based on the embodiments of the present disclosure, all other embodiments obtained by those skilled in the art without any creative effort fall within the protection scope of the present disclosure.

In the following detailed description, although numerous specific details are set forth to provide a thorough understanding of the present disclosure, the present disclosure may also be implemented by other embodiments than embodiments described herein. Those skilled in the art may promote similarly without departing from the connotation of the present disclosure. Therefore, the present disclosure is not limited to the following disclosed specific embodiments.

As described in the background part, in conventional technologies, a front electrode of one solar cell and a back electrode of an adjacent solar cell overlap with each other by adopting conducting resin to form a series circuit. Though output power of a photovoltaic module can be improved to a certain extent, the photovoltaic module has a large package loss, which results in a large power consumption inside the photovoltaic module. In addition, processes such as applying conducting resin, curing and terminal welding and related devices are additionally required, which results in a complex process and a high production cost.

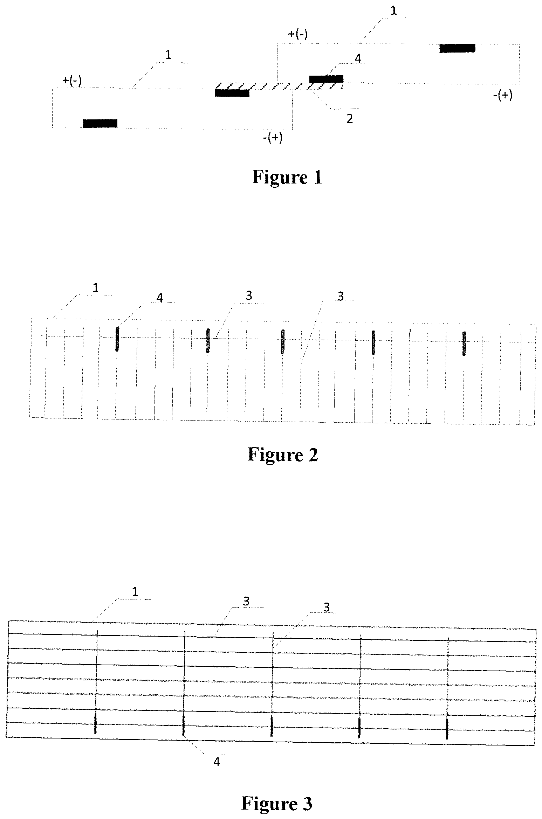

In view of this, a photovoltaic cell array is provided according to the present disclosure. Referring to Figure 1, Figure 1 is a cross-sectional view of adjacent two solar cells in a photovoltaic cell array according to the present disclosure in a direction along a short side of each of the adjacent two solar cells. The photovoltaic cell array includes multiple solar cells 1 and a flexible metal conductive strip 2. Each of an upper surface and a lower surface of each solar cell is arranged with a segment electrode 4. In adjacent two of the multiple solar cells 1 which are respectively referred to as a first solar cell and a second solar cell, the segment electrode 4 on the lower surface of the first solar cell is connected with the segment electrode 4 on the upper surface of the second solar cell with the flexible metal conductive strip 2. In addition, the photovoltaic cell array has a stack structure in a normal direction on the upper surface of the solar cell 1. A connection region at which the segment electrode is connected with the flexible metal conductive strip is located outside an overlapped region of the stack structure.

In the present embodiment, the segment electrode 4 on the lower surface of the first solar cell in the adjacent two solar cells 1 is connected with the segment electrode 4 on the upper surface of the second solar cell in the adjacent two solar cells 1 by the flexible metal conductive strip 2, since the flexible metal conductive strip 2 has a small resistance, the flexible metal conductive strip 2 causes a small power loss when the photovoltaic cell array produces a current after receiving solar radiation, such that the output power of the photovoltaic cell array can be increased. A width of the flexible metal conductive strip 2 is equal to a width of the segment electrode 4.

Specifically, the flexible metal conductive strip may be a solder strip or a flexible conductive strip made of another metallic material.

Further, in the present embodiment, the photovoltaic cell array has the stack structure in the normal direction of the upper surface of the solar cell 1, since the adjacent solar cells 1 are stacked with each other, the number of the solar cells 1 in the photovoltaic cell array can be increased for the photovoltaic cell array with a fixed length, thereby such that a light receiving area is increased, thus improving the output power of the photovoltaic cell array.

Further, in the present embodiment, the connection region at which the flexible metal conductive strip is connected with the segment electrode is located outside the overlapped region of the stack structure, such that it is convenient to perform a rework process when a failure occurs at the connection region such as a loose connection.

It should be noted that, in the present disclosure, the solar cell 1 is a rectangular (quasi rectangular) plate. A ratio of length of a long side to that of a short side of the solar cell 1 ranges from 4 to 20, inclusive.

It should be noted that, in the present embodiment, the solar cell 1 may be obtained by, but not limited to, dividing a square (quasi square) solar cell or another rectangular (quasi rectangular) solar cell.

The segment electrode 4 is configured to collect the current generated by the solar cell and transmits the current to the flexible metal conductive strip 2. For a double-sided solar cell, each of an upper surface and a lower surface of the double-sided solar cell is arranged with metal fine grid wires, and the segment electrode 4 is connected to the metal fine grid wires to collect current. For a single-sided solar cell, an upper surface of the single-sided solar cell is arranged with metal fine grid wires, and a lower surface of the single-sided solar cell is arranged with an aluminum back surface field, rather than the metal fine grid wires. The segment electrode 4 arranged on the upper surface of the single-sided solar cell is connected to the metal fine grid wires, and the segment electrode 4 arranged on the lower surface of the single-sided solar cell is directly connected to the aluminum back surface field.

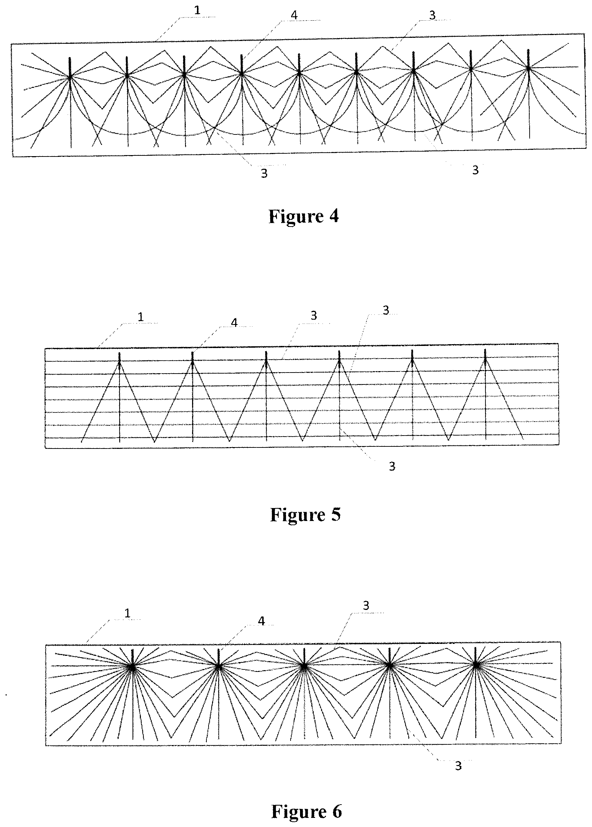

It also should be noted that, in the present embodiment, a distribution patterns of the metal fine grid wires on the upper surface of the double-sided solar cell, the lower surface of the double-sided solar cell and the upper surface of the single-sided solar cell are not limited in the present disclosure, which are determined according to actual needs. Referring to Figure 2 to Figure 6, Figure 2 to Figure 6 show five distribution patterns of metal fine grid wires 3 on a surface of a solar cell. Preferably, for the double-sided solar cell, the metal fine grid wires 3 on the upper surface has the same distribution pattern as the metal fine grid wires 3 on the lower surface, to simplify a production process, so as to improve production efficiency.

It can be understood that, in a case that the lower surface of the first solar cell in the adjacent two solar cells 1 is connected with a negative electrode, the upper surface of the second solar cell is connected with a positive electrode. Similarly, in a case that the lower surface of the first solar cell is connected with a positive electrode, the upper surface of the second solar cell is connected with a negative electrode.

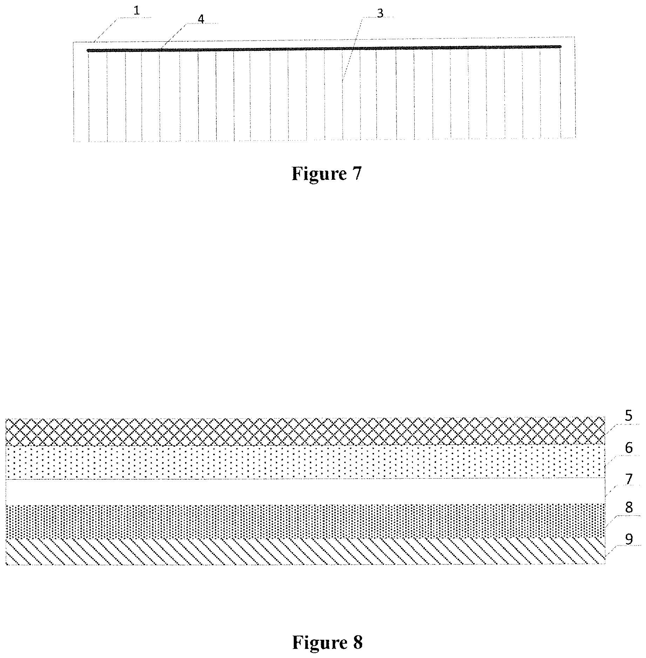

Specifically, in an embodiment of the present disclosure , as shown in Figure 7, the segment electrode 4 is arranged with a length direction of the segment electrode 4 parallel to the long side of the solar cell 1, but the present disclosure is not limited thereto. In another embodiment of the present disclosure, the segment electrode 4 is arranged with the length direction of the segment electrode 4 perpendicular to the long side of the solar cell 1. In another embodiment of the present disclosure, there is an angle between the segment electrode 4 and a first side of the solar cell 1, which is an acute angle, where the first side is the long side of the solar cell 1. It may be understood that, two segment electrodes 4 respectively in adjacent two solar cells 1 are connected to each other by the flexible metal conductive strip 2, such that a positional relationship between the segment electrode 4 and the long side of the solar cell 1 represents a positional relationship between the flexible metal conductive strip 2 and the long side of the solar cell 1. For example, in a case that the segment electrode 4 is arranged with the length direction of the segment electrode 4 perpendicular to the long side of the solar cell 1, the flexible metal conductive strip 2 is arranged perpendicular to the long side of the solar cell 1.

It may also be understood that, regardless of an angle between the segment electrode 4 and a side of the solar cell 1, the segment electrode 4 transmits the collected current to the flexible metal conductive strip 2, and a direction in which the current flows is parallel to the surface of the solar cell 1.

The photovoltaic cell array provided according to the present disclosure includes multiple solar cells 1 and the flexible metal conductive strip 2. Each of an upper surface and a lower surface of each of the multiple solar cells 1 is arranged with a segment electrode 4. In adjacent two of the multiple solar cells 1 which are respectively referred to as a first solar cell and a second solar cell, the segment electrode 4 on the lower surface of the first solar cell is connected with the segment electrode 4 on the upper surface of the second solar cell with the flexible metal conductive strip 2. The photovoltaic cell array has a stack structure in a normal direction of the upper surface of each of the multiple solar cells, and a connection region at which the segment electrode is connected with the flexible metal conductive strip is located outside an overlapped region of the stack structure. In the present disclosure, two adjacent solar cells 1 in the photovoltaic cell array are connected with each other by the flexible metal conductive strip 2, since the flexible metal conductive strip 2 has a low cost, a small resistance, and a small power consumption, the output power of the photovoltaic cell array can be improved and the production cost of the module can be reduced. In addition, since the adjacent two solar cells 1 in the photovoltaic cell array form the stack structure in the normal direction of the upper surface of the solar cell, the number of the solar cells 1 can be increased for the photovoltaic cell array with a fixed length, such that the light receiving area is increased, thereby improving the output power of the photovoltaic cell array. Compared with a conventional module, although output power of an imbricate photovoltaic module is improved, processes such as applying conducting resin, curing and terminal welding and related devices are additionally required, which results in a complex process and a high production cost. However, in the embodiment, the solder strip is adopted, which can simplify the production process and reduce the production cost.

Further, in an embodiment of the present disclosure, in a case that the segment electrode 4 is arranged with the length direction of the segment electrode 4 perpendicular to the long side of the solar cell 1, the number of the segment electrode 4 is not specifically limited according to the present embodiment.

In an embodiment, based on above embodiments, in an embodiment of the present disclosure, the number of the segment electrode 4 may range from 1 to 12, inclusive.

Preferably, in a case that the segment electrode 4 is arranged perpendicular to the first side of the solar cell 1, the number of the segment electrode 4 located on each of the upper surface and the lower surface of the solar cell ranges from 4 to 9, inclusive, where the solar cell 1 is a rectangular plate, and the first side is the long side of the solar cell 1. In addition, it is required to avoid the number of the segment electrodes from being too small, this is because that if the number of the segment electrode is too small, not all current of the solar cells can be collected, resulting in a waste of the current, failing to efficiently improve the output power of the photovoltaic cell array. In addition, it is also required to avoid the number of the segment electrodes 4 from being too large, this is because that the segment electrode 4 is connected to the flexible metal conductive strip 2, such that the solar cell 1 is shielded, which can reduce the light receiving area on the solar cell 1, resulting in an reduced output power of the photovoltaic cell array.

Based on above embodiments, in an embodiment of the present disclosure, in a case that the number of the segment electrodes 4 is two or more, the segment electrodes 4 are arranged uniformly on each of the upper surface and the lower surface of the solar cell.

Based on above embodiments, in an embodiment of the present disclosure, a width of the segment electrode 4 ranges from 0.5mm to 5mm, inclusive. It is required to avoid the width of the segment electrode 4 from being too small, this is because that the flexible metal conductive strip 2 is to be welded to the segment electrode 4, a weld region between the flexible metal conductive strip 2 and the segment electrode 4 is weak in a case that the width of the segment electrode 4 is too small. In addition, it is also required to avoid the width of the segment electrode 4 from being too large, because a region in which the segment electrode 4 is located can not receive light to generate electricity once the flexible metal conductive strip 2 is welded to the segment electrode 4, thus an effective area of the solar cell 1 is reduced, resulting in a reduced overall output power of the photovoltaic cell array.

Based on above embodiments, in an embodiment of the present disclosure, a length of the segment electrode 4 ranges from 1mm to 15mm, inclusive. It is required to avoid the length of the segment electrode 4 from being too small, this is because that the flexible metal conductive strip 2 is to be welded to the segment electrode 4, a small contact region may be caused between the flexible metal conductive strip 2 and the segment electrode 4 if the length of the segment electrode 4 is too small, resulting in a weak weld region. In addition, it is required to avoid the length of the segment electrode 4 from being too large, this is because that a region in which the segment electrode 4 is located can not receive light to produce current, a large region of the solar cell 1 is shielded in a case that the length of the segment electrode 4 is too large, which may reduce the power generation efficiency, resulting in a reduced overall output power of the photovoltaic cell array.

Based on above embodiments, in an embodiment of the present disclosure, a thinkness of the flexible metal conductive strip 2 is less than 200µm. It is required to avoid the thinkness of the flexible metal conductive strip 2 from being too large, this is because that adjacent two solar cells 1 are connected in a stack manner by the flexible metal conductive strip 2 and a distance between the adjacent two solar cells 1 is equal to the thinkness of the flexible metal conductive strip 2, the distance between the adjacent two solar cells 1 is large in a case that the thinkness of the flexible metal conductive strip 2 is large, which may results in a large overall height of the photovoltaic cell array, thereby affecting a use of the photovoltaic cell array. In addition, if the overall height of the photovoltaic cell array is large, in a process of fabricating a photovoltaic module using the photovoltaic cell array, the solar cell 1 of the photovoltaic cell array is easily broken during lamination, which reduces a product qualified rate and increases the production cost.

Preferably, in an embodiment of the present disclosure, the stack structure is formed by stacking the adjacent two solar cells 1 along a first side of each solar cell 1, where the first side is a long side of the solar cell 1. Preferably, the metal fine grid wires 3 are arranged in a direction parallel to a short side of the solar cell 1. The stack structure is formed by stacking adjacent two solar cells 1 along the first side of each solar cell 1, that is, the adjacent two solar cells 1 are stacked along the long side of the solar cell 1. The metal fine grid wires 3 on a surface of the solar cell 1 are used to carry current in the solar cell 1 and transmit the current to the outside of the solar cell 1. A distance through which the current in the metal fine grid wires 3 flows is equal to a length of the short side of the solar cell 1. A short distance through which the current flows cause a small power consumed inside the solar cell 1, thus the output power of the photovoltaic cell array is large. In addition, since the adjacent two solar cells 1 are stacked along the long side of the solar cell 1, the photovoltaic module is fabricated without improving the conventional production equipment, which is realized by a simple process.

Preferably, in an embodiment of the present disclosure, a width of an overlapped region of the stack structure is less than 2mm. It is required to avoid the width of the overlapped region of the stack structure of the photovoltaic cell array from being too large, this is because that the overlapped region can not receive light, that is, an effective area of the solar cell 1 is reduced due to the overlapped region, which reduces the overall output power of the photovoltaic cell array.

Preferably, in a case that the solar cells 1 are stacked in the long side of the solar cell 1, a length of the flexible metal conductive strip 2 by which adjacent two solar cells 1 are connected is less than a half of a length of a short side of the solar cell 1.

A photovoltaic module is further provided according to the present disclosure. Referring to Figure 8, Figure 8 is a structural diagram of a photovoltaic module according to an embodiment of the present disclosure. The photovoltaic module includes a glass substrate 5, an EVA photoresist film layer 6, the photovoltaic cell array 7 described in any one of the above embodiments, an EVA photoresist film layer 8 and a backplane 9 that are stacked in the listed sequence from top to bottom.

The photovoltaic cell array in the photovoltaic module according to the present disclosure includes multiple solar cells 1 and the flexible metal conductive strip 2. Each of an upper surface and a lower surface of each of the multiple solar cells 1 is arranged with a segment electrode 4. In adjacent two of the multiple solar cells 1 which are respectively referred to as a first solar cell and a second solar cell, the segment electrode 4 on the lower surface of the first solar cell is connected with the segment electrode 4 on the upper surface of the second solar cell with the flexible metal conductive strip 2. The photovoltaic cell array has a stack structure in a normal direction of the upper surface of each of the multiple solar cells, and a connection region at which the segment electrode is connected with the flexible metal conductive strip is located outside an overlapped region of the stack structure. In the present disclosure, two adjacent solar cells 1 in the photovoltaic cell array are connected with each other by the flexible metal conductive strip 2, since the flexible metal conductive strip 2 has a low cost, a small resistance, and a small power consumption, the output power of the photovoltaic cell array can be improved and the production cost of the module can be reduced. In addition, since the adjacent two solar cells 1 in the photovoltaic cell array form the stack structure in the normal direction of the upper surface of the solar cell, the number of the solar cells 1 can be increased for the photovoltaic cell array with a fixed length, such that the light receiving area is increased, thereby improving the output power of the photovoltaic cell array.

The embodiments in this specification are described in a progressive way, each of which emphasizes the differences from others, and the same or similar parts among the embodiments can be referred to each other. Since the device disclosed in the embodiments is corresponding to the method therein, the description thereof is relatively simple, and for relevant matters references may be made to the description of the method.

The photovoltaic cell array and the photovoltaic module according to the present application are introduced above in detail. Specific examples are used herein to illustrate the principle and embodiments of the present disclosure. The above illustration of the embodiments is only to help in understanding the method and the core idea of the present disclosure. It should be noted that those skilled in the art can change or modify the present disclosure without departing from the principle of the present disclosure and the changes and modifications fall within the protection scope of the claims of the present disclosure.

## Claims

1. A photovoltaic cell array, comprising a plurality of solar cells and a flexible metal conductive strip, wherein
each of an upper surface and a lower surface of each of the plurality of solar cells is arranged with a segment electrode,
in adjacent two of the plurality of solar cells which are respectively referred to as a first solar cell and a second solar cell, the segment electrode on the lower surface of the first solar cell is connected with the segment electrode on the upper surface of the second solar cell by the flexible metal conductive strip, and
the photovoltaic cell array has a stack structure in a normal direction of the upper surface of each of the plurality of solar cells, and a connection region at which the segment electrode is connected with the flexible metal conductive strip is arranged outside an overlapped region of the stack structure.

2. The photovoltaic cell array according to claim 1, wherein in a case that the segment electrode is arranged in a direction perpendicular to a first side of the solar cell, the number of the segment electrode arranged on each of the upper surface and the lower surface of the solar cell ranges from 4 to 9, inclusive, and wherein the solar cell is a rectangular plate, and the first side is a long side of the solar cell.

3. The photovoltaic cell array according to claim 2, wherein the segment electrode is arranged uniformly on each of the upper surface and the lower surface of the solar cell.

4. The photovoltaic cell array according to claim 3, wherein a width of the segment electrode ranges from 0.5mm to 5mm, inclusive.

5. The photovoltaic cell array according to claim 4, wherein a length of the segment electrode ranges from 1mm to 15mm, inclusive.

6. The photovoltaic cell array according to claim 1, wherein a thinkness of the flexible metal conductive strip is less than 200µm.

7. The photovoltaic cell array according to claim 1, wherein the adjacent two solar cells are stacked with each other along a first side of each of the two adjacent solar cells to form the stack structure, and wherein the solar cell is a rectangular plate, and the first side is a long side of the solar cell.

8. The photovoltaic cell array according to claim 1, wherein an angle between the segment electrode and a first side of the solar cell is an acute angle.

9. The photovoltaic cell array according to any one of claim 1 to 8, wherein a width of the overlapped region of the stack structure is less than 2mm.

10. A photovoltaic module, comprising the photovoltaic cell array according to any one of claim 1 to 9.
